Europäisches Patentamt

European Patent Office

Office européen des brevets

(19)

(11) Veröffentlichungsnummer: **0 132 728**

**A1**

(12) ## EUROPÄISCHE PATENTANMELDUNG

(21) Anmeldenummer: **84108287.8**

(22) Anmeldetag: **13.07.84**

(51) Int. Cl.⁴: **G 01 R 15/06**

(30) Priorität: **21.07.83 DE 3326283**

(43) Veröffentlichungstag der Anmeldung:
**13.02.85 Patentblatt 85/7**

(84) Benannte Vertragsstaaten:
**AT BE CH DE FR LI SE**

(71) Anmelder: **MWB MESSWANDLER-BAU AG
Nürnberger Strasse 199
D-8600 Bamberg(DE)**

(72) Erfinder: **Zürker, Hermann, Dipl.-Ing.
Jahnstrasse 44
D-8600 Bamberg(DE)**

(74) Vertreter: **Hufnagel, Walter, Dipl.-Ing.,
Dipl.-Wirtsch.-Ing. et al,
Dorner & Hufnagel Patentanwälte Bad Brückenauer Str.
19
D-8500 Nürnberg 90(DE)**

(54) **Einrichtung zur Überwachung hoher Wechselspannungen.**

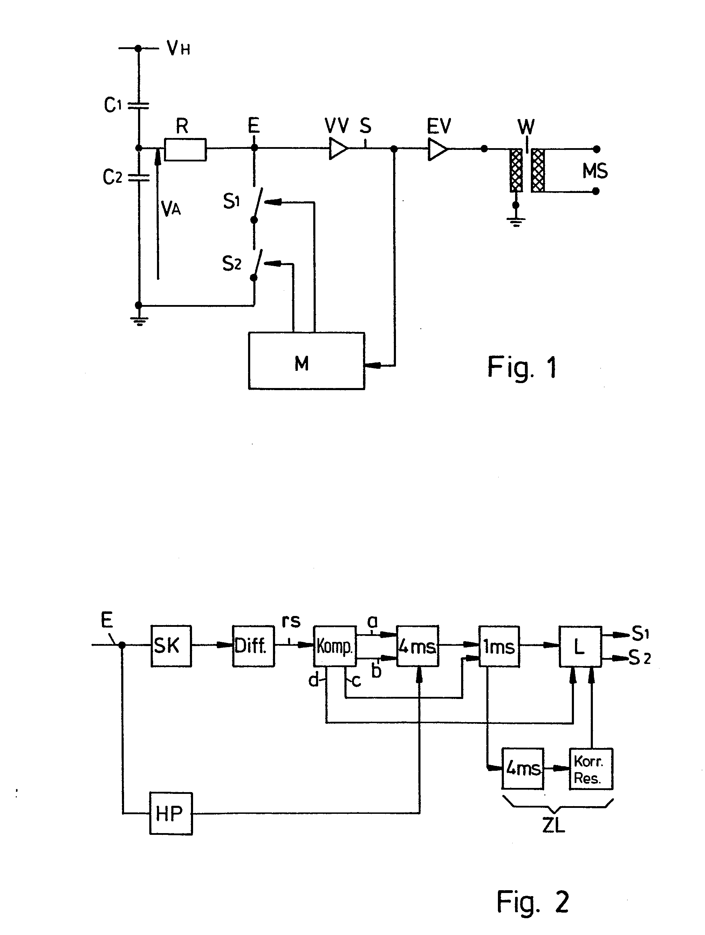

(57) Eine Einrichtung mit einem Verstärker und einer Steuervorrichtung zur Überwachung hoher Wechselspannungen ist so ausgebildet, daß der am Unterspannungskondensator eines kapazitiven Spannungsteilers anstehende Gleichspannungsanteil sehr schnell, d.h. möglichst innerhalb der ersten Halbperiode zu entfernen ist, wobei möglichst wenig Meß- und Steueraufwand betrieben werden soll. Hierfür ist eine Meß- und Steuervorrichtung (M) vorgesehen, die den ersten Scheitelpunkt nach Wiedereinschaltung erkennt und nach einer Verzögerungszeit von einigen Millisekunden nach dem Scheitelpunkt die Schaltanordnung (S₁, S₂) für einen Bruchteil der Verzögerungszeit in Durchlaßrichtung steuert, so daß die Schaltanordnung (S₁, S₂) im Nullpunkt oder vor Erreichen des Nullpunkts wieder geöffnet ist (Figur 1).

Fig. 1

EP 0 132 728 A1

0132728

MWB MESSWANDLER-BAU AG
Bamberg

## Einrichtung zur Überwachung hoher Wechselspannungen

Die vorliegende Erfindung bezieht sich auf eine Einrichtung mit einem Verstärker zur Überwachung hoher Wechselspannungen gemäß dem Oberbegriff des Anspruches 1.

Ein derartiges Gerät ist bereits aus der DE-OS 26 34 595 bekannt. Dort ist parallel zum an Masse liegenden Kondensator eines kapazitiven Spannungsteilers als Schaltvorrichtung die Reihenschaltung eines Schalters mit einem sehr niederohmigen Widerstand und außerdem eine Steuervorrichtung dazu parallel angeschlossen. Die Steuervorrichtung öffnet nach dem Wiedereinschalten der Wechselspannung den Schalter in Abhängigkeit vom ersten Nulldurchgang nach einer Verzögerungszeit von etwa 1 Millisekunde. Unter normalen Arbeitsbedingungen wird hierdurch der normale Betriebszustand nicht später als nach einer halben Schwingungsperiode nach der Wiedereinschaltung der Leitung erreicht und der Eingang ist während dieser Zeit kurzgeschlossen.

Der Erfindung liegt folgende Problemstellung zugrunde:

Die Messung hoher Spannungen geschieht derzeit zumeist mit induktiven Spannungswandlern. Je höher die Spannungsebene wird, desto teurer werden diese Einrichtungen.

In der Vergangenheit wurden daher immer wieder Versuche unternommen, die Hochspannungsmessung mittels kapazitiver Hochspannungsteiler und nachfolgender Meßverstärker durchzuführen.

Ein Problem stellt dabei das Auftreten von Gleichspannungsgliedern in dem kapazitiven Teiler dar. Diese Gleichspannungen treten dann auf, wenn der unter Hochspannung stehende Teiler in einem Augenblick abgeschaltet wird, in welchem die Spannung nicht Null ist. Dann bleibt am Verstärkereingang eine Gleichspannung anstehen. Selbst wenn diese über den Eingangswiderstand des Verstärkers abgebaut ist, tritt beim Wiederzuschalten der Hochspannung die im Oberspannungskondensator gespeicherte Ladung als Gleichspannungskomponente auf, die der Wechselspannung unterlagert ist. Das verschiebt die für Schutzeinrichtungen wichtigen Nulldurchgänge der Ausgangsspannung und führt bei potentialfreien Wandlerausgängen zu deren Sättigung.

Es wurde schon vorgeschlagen, zwecks schnelleren Abbaus dieser Gleichspannungen eine Entladeimpedanz an den Unterspannungskondensator anzuschalten. (Bulletin Scientifique A.I.M., Juni 73, S. 154, 155) Aber diese Maßnahme ist auch bei bescheidener Beschaltung mit erheblichen Phasenverschiebungen verbunden, so daß auch während des Betriebes die Primärspannung nicht mehr richtig abgebildet wird.

0132728

In Verbesserung dieser einfachen Schaltung ist in der DE-OS 28 46 285 eine Schaltung vorgeschlagen, bei der die Entladeimpedanz bei Feststellung von Gleichspannungskomponenten zu- und nach einigen Perioden wieder abgeschaltet wird, was die oben beschriebenen Nachteile nur während einer kürzeren Zeit hervorruft.

In derselben Literaturstelle ist ein zweiter Hochspannungsteiler vorgesehen, der einen zweiten, Gleichspannung sperrenden Verstärkereingang speist und es wurden Teiler vorgeschlagen, die mehrere Meß- oder Steuerkondensatoren enthalten, um verschiedene Eingangsspannungen verschieden zu verarbeiten und logische Entscheidungen zu treffen, die ein Glied veränderlicher Impedanz am Meßeingang im Sinne der Gleichspannung mehrere Halbperioden lang abwechselnd ein- und ausschaltet bis die Gleichspannungskomponente abgeklungen ist.

Das Glied veränderlicher Impedanz ist im einfachsten Fall ein Widerstand und ein in Reihe dazu angeordneter Schalter. Es kann auch ein in seinem Widerstand steuerbarer Halbleiter oder ein Register von Schaltern mit gleichen oder verschiedenen Widerständen sein, wie sie von Digital-Analogwandlern bekannt sind.

Weiterhin wurden Verstärker mit rein elektronischen Filtern gebaut, die die Gleichkomponente aus dem Meßsignal ausfiltern. Aber dabei ist es sehr schwierig, die heutigen Anforderungen an Genauigkeit nach Amplitude und Phase, an den Frequenzgang und das Einschwingverhalten zu einem tragbaren Kompromiß zu führen. Ferner ist eine solche

- 4 -

0132728

Anordnung schwierig, auf ihre Betriebssicherheit zu
überwachen - wie das üblicherweise mit dem sogenannten
Längsvergleich erfolgt -, da für eine Übergangszeit die
Ausgangsspannung nicht gleich der Eingangsspannung ist.

Heutige schnelle Schutzeinrichtungen verlangen schon nach
Millisekunden nach Verstärkerausgangsspannungen, die ein
gutes Abbild der Hochspannung sind und keine zu Fehlschaltungen führenden Verlagerungen oder Verschiebungen
enthalten.

Diese Aufgabenstellung führte zu den vorbekannten Lösungen
gemäß der DE-OS 28 46 285 und der DE-OS 26 34 595. Der
Grundgedanke der DE-OS 26 34 595 ist - im Gegensatz zum
Gegenstand gemäß der DE-OS 28 46 285 -, daß der Gleichspannungsanteil nicht allmählich in mehreren Schritten,
sondern kurzzeitig und schlagartig zum frühestmöglichen
Zeitpunkt aus dem einfachen Hochspannungsteiler total entfernt wird.

Aufgabe der Erfindung ist es, demgegenüber eine Einrichtung der eingangs erwähnten Art vorzuschlagen, mit der
der Gleichspannungsanteil sehr schnell, d.h. möglichst
ebenfalls innerhalb der ersten Halbperiode zu entfernen
ist und dabei möglichst wenig Meß- und Steueraufwand betrieben werden muß.

Erfindungsgemäß wird diese Aufgabe durch die im Kennzeichen des Anspruches 1 angegebenen Merkmale gelöst.

Hierbei muß also lediglich der Scheitelwert der wieder zugeschalteten Spannung gemessen werden. Durch die Zeitglieder, nämlich die Verzögerung um 4 Millisekunden und das kurzzeitige Schließen des Schalters bzw. der Schaltanordnung über eine Zeitspanne von 1 Millisekunde wird bei 50 Hz Betriebsfrequenz der hohen Wechselspannung der Anteil der Gleichspannung 1 Millisekunde vor dem Spannungsnulldurchgang nach Masse oder an eine Referenzspannung geschaltet und dieser Gleichspannungsanteil bis zum Nulldurchgang praktisch vollkommen entfernt. Dadurch erfolgt die Erfassung der nach dem Schließen des Hochspannungsschalters wieder eintreffenden Wechselspannungswelle völlig unbelastet durch den geschalteten Widerstand. Hierzu bedarf es keiner nochmaligen Messung, beispielsweise des Nulldurchgangs, wie dies beim Gegenstand gemäß der DE-OS 26 34 595 erforderlich ist.

Gemäß einer vorteilhaften Ausgestaltung der Erfindung kann der Widerstand zum Schutz der Schaltanordnung als Vorwiderstand im Zuge der Eingangsleitung vorgesehen sein und die Schaltanordnung, insbesondere ein mechanischer Schalter, ist vom Eingang aus nach Masse oder gegen eine besondere Referenzspannung geschaltet.

Da kein analoger oder quasi-analoger Eingriff in das Meßsignal vorgenommen wird, sieht eine Weiterbildung der Erfindung eine Verstärkerüberwachung (Längsvergleich) vor, die während oder nach der kurzzeitigen Korrektur am Ein-und am Ausgang die gleiche Amplitude aufweist, so daß die Betriebsüberwachung entsprechend schnell ausgeführt werden kann. Dies ist eine wichtige Forderung moderner elektronischer Schutzeinrichtungen.

Weitere vorteilhafte Einzelheiten der Erfindung werden nachfolgend anhand eines in der Zeichnung veranschaulichten Ausführungsbeispieles beschrieben. Dabei zeigen:

Fig. 1  einen kapazitiven Spannungsteiler mit einer prinzipiellen Schaltungsausführung gemäß der Erfindung  und

Fig. 2  ein vorteilhaftes Schaltschema für die verwendete Steuereinheit.

Am Eingang E eines Vorverstärkers VV liegt die Ausgangsspannung $V_A$ eines kapazitiven Spannungsteilers $C_1$, $C_2$ über einen sehr niederohmigen Widerstand R an. Diese Spannung $V_A$ wird gewonnen von einem Teilerabgriff eines aus z.B. zwei Kondensatoren $C_1$ und $C_2$ gebildeten kapazitiven Spannungsteilers. Der obere Anschluß des Oberspannungskondensators $C_1$ liegt an einer Hochspannungs-Wechselspannung $V_H$ und der untere Anschluß des Unterspannungskondensators $C_2$ liegt auf Massepotential. Von E aus ist ein Schalter $S_1$ oder sind gegebenenfalls zwei Schalter $S_1$ und $S_2$ in Reihe nach Masse geschaltet, so daß der Unterspannungskondensator $C_2$ über den Widerstand R kurzgeschlossen werden kann.

Der eine der beiden Schalter $S_1$, $S_2$ kann zur Erhöhung der Sicherheit vorgesehen sein. Die Ansteuerung der Schalter

$S_1$, $S_2$ erfolgt über eine Meß- und Steuervorrichtung M, die am Ausgang des Vorverstärkers VV angeschlossen ist oder in die der Vorverstärker integriert sein kann.

Das Signal S wird in einem Endverstärker EV verstärkt und einem Wandler W zugeleitet, dem Meßsignale MS zu entnehmen sind.

Die Meß- und Steuervorrichtung M enthält gemäß Fig. 2 zweckmäßig einen Scheitelspannungskompressor SK, der einen steilen Spannungsgradienten bildet und daher auch bei kleinen Scheiteln, d.h. niedrigen Amplituden, eine einwandfreie Scheitelerkennung garantiert. Dadurch wird auch bei Spannungen, die kleiner als die Hochspannungswechselspannung VH ist, eine gute zeitliche Präzision der Scheitelerkennung erreicht. Auf diesen folgt eine zweckmäßig stark übersteuerbare Differenzierstufe Diff., in der aus der Wechselspannung ein Rechtecksignal erzeugt wird, das gegen die Eingangsspannung E um 90$^o$ phasenverschoben ist. Dieses Rechtecksignal rs wird einer Komparatorstufe Komp. eingegeben. Diese erzeugt einerseits Scheitelimpulse, mit denen die nachfolgenden Zeitstufen für 4 Millisekunden Verzögerungszeit und 1 Millisekunde Schaltdauer getriggert werden. Andererseits verarbeitet die Komparatorstufe Bedingungen, mit denen echte Scheitelimpulse vom Einschaltvorgang unterschieden werden und mit denen innerhalb von wenigen Millisekunden an eine nachfolgende Logik L gemeldet wird, wenn die Hochspannung abgeschaltet wurde, auch wenn der Teiler Restspannungen enthält.

Zu diesem Zweck ist die Komparatorstufe so aufgebaut, daß das Differenzier-Ausgangssignal mit einer positiven und

0132728

einer negativen Schwellspannung verglichen wird und die dazu notwendigen beiden Komparatoren bei anstehendem Wechselspannungssignal immer in Phasenopposition stehen, bei Wechselspannungswert Null aber in gleicher Phase.

Aus dieser einfachen Anordnung werden alle ausgehenden Steuersignale dieser Stufe abgeleitet.

Der Zeitkette (4 ms + 1 ms) nachgeschaltet ist die Logik L, die den Korrekturimpuls nur einmal bei jedem Einschaltvorgang aktiv werden läßt.

Diese Schaltung muß bei jeder Unterbrechung des Eingangssignales wieder aktiviert werden, was von der Komparatorschaltung aus (über die Wirkungslinie d) geschieht, und zwar nach bereits ca. 5 Millisekunden.

Gleichzeitig stößt die Komparatorschaltung (über die Wirkungslinie c) direkt die 1 ms-Aktivzeit an und vernichtet damit mittels kurzzeitigem Kurzschlusses die beim Abschalten des Teilers "eingefrorene" Spannung des Unterspannungskondensators $C_2$.

Damit wird die Sättigung des Ausgangswandlers W und daraus folgend auch das Ansprechen des Längsvergleichs verhindert.

Ein großes Problem sind die beim Schalten von Hochspannung entstehenden Überschläge, auch Vorzündungen genannt, die natürlich über den Differenzierer falsche (Scheitel-)Impulse an die Schaltung abgeben. Würden diese Impulse nicht unterdrückt, dann könnte ein zur falschen Zeit ausgelöster Impuls nicht nur die Gleichspannungskomponente noch vergrößern, sondern er stünde auch nicht mehr zur Verfügung, wenn die Störungen aufgehört haben.

Diesem Zweck dient die Störungserkennung über das Hochpaßfilter HP, das die Wirkung der falschen Triggerung bei jeder HF-Störung wieder aufhebt. Damit wird der Puls aufgespart, bis eine saubere Scheitelerkennung möglich ist.

Um auch in dem Fall, wenn die eine ungünstige zeitliche Lage von Störpulsen eine falsche Auslösung des Pulses durchläuft, noch eine Korrekturreserve (Korr.Res. in Fig. 2) zu haben, ist eine Zusatzlogik ZL eingebaut, die die Zeit nach dem Korrekturimpuls bis zum Eintreffen des regulären nächsten Scheitelimpulses auf Scheitelfreiheit überwacht. Käme in dieser Zeit ein Scheitelimpuls, so würde anschließend nochmal ein zweiter Korrekturimpuls abgegeben.

Anstelle des und/oder der Schalter $S_1$, $S_2$ kann diese Kurzschluß-Schaltanordnung auch durch Halbleiter, wie Triacs oder antiparallele Transistoren oder Thyristoren, mit geringem Leckstrom gebildet sein.

Auch kann anstelle der Schaltung von E nach Masse über die Schaltanordnung $S_1$, $S_2$ eine Referenzspannung an den Spannungsteiler $C_1$, $C_2$ angelegt werden. Diese wäre vorzugsweise entgegengesetzt gleich groß wie die beim Schließen der Schaltanordnung $S_1$, $S_2$ wirksame Ausgangsspannung VA. Dadurch kann eine noch kürzere Korrekturzeit von z.B. unter 1 Millisekunde erreicht werden.

Das vorstehend beschriebene zeitgesteuerte Verfahren bemüht sich nicht, den Gleichspannungsanteil nach Größe und Polarität festzustellen, sondern setzt stereotyp beim Einschalten zum frühest möglichen Zeitpunkt, d.h. 5 Millisekunden nach dem ersten erkennbaren Scheitel, seinen Korrekturimpuls ab, also auch dann, wenn gar keine Gleichspannung da ist.

Eine Gleichspannungsdetektion vor der Korrektur ist auch grundsätzlich bei längerer Erfassungszeit (+ 10 Millisekunden) bis zur Korrektur möglich. Diese Methode funktioniert so:

Bei der ersten Scheitelerkennung wird eine analoge Hold-Schaltung mit der Scheitelspannung aufgeladen, bei der darauffolgenden Scheitelerkennung eine zweite mit diesem Wert. Sobald das abgeschlossen ist, wird der Mittelwert aus beiden Scheitelspannungen gebildet und als - jetzt spannungsabhängiges - Steuerkriterium für die Kontaktauslösung herangezogen.

Eine weitere Variante ist wie folgt möglich:

Die Gleichspannungs-Detektion erfolgt über eine Tiefpaß-Filterschaltung, gefolgt von einem Vergleich mit der direkten Meßspannung. Bei Erreichen des stationären Gleichspannungswertes, Aufladen eines Kondensators (von gleicher Größe wie die Quellkapazität des Teilers) mit der entgegengesetzt gleichen Spannung erfolgt Kurzschließen beider über "Schalter".

Dadurch erfolgt die Schaltung unabhängig vom Zeitpunkt des Nulldurchganges und wird dadurch eventuell noch etwas
schneller, und zwar besonders bei ungünstigen Einschaltaugenblicken, wie kurz nach dem Scheitel, wobei jetzt bis
zu 15 Millisekunden bis zur Korrektur vergehen können.

Auch diese Ausführungsform der Erfindung trägt das Merkmal des sehr kurzzeitigen schlagartigen Eingriffes, das
sie von den bekannten Anordnungen unterscheidet.

- - - - - -

MWB MESSWANDLER-BAU AG
Bamberg

0132728

P a t e n t a n s p r ü c h e
- - - - - - - - - - - - - -

1. Einrichtung mit einem Verstärker und einer Steuervorrichtung zur Überwachung hoher Wechselspannungen mit einem kapazitiven Spannungsteiler für die zu überwachende Wechselspannung und mit einer an einem kapazitiven Zweig des Spannungsteilers angeschlossenen Schaltvorrichtung zum kurzfristigen Entfernen des nach einem Abschalten oder einer Unterbrechung der Wechselspannung und anschließender Wiederzuschaltung der Leitung am Unterspannungskondensator entstehenden Gleichspannungsanteils, wobei diese Schaltvorrichtung eine am Eingang des Verstärkers angebrachte Schaltanordnung enthält, die über die Steuervorrichtung die Eingangsspannung innerhalb der ersten halben Schwingungsperiode nach dem Wiedereinschalten kurzzeitig und zeitlich genau gesteuert über einen sehr niederohmigen Widerstand kurzschließt, d a d u r c h   g e k e n n - z e i c h n e t ,   daß eine Meß- und Steuervorrichtung (M) vorgesehen ist, die den ersten Scheitelpunkt nach Wiedereinschaltung erkennt und nach einer Verzögerungszeit von einigen Millisekunden, insbesondere nach 4 Millisekunden, nach dem Scheitelpunkt die Schaltanordnung ($S_1$, $S_2$) für einen Bruchteil der Verzögerungszeit, insbesondere für 1 Millisekunde, in Durchlaßrichtung steuert, so daß die Schaltanordnung ($S_1$, $S_2$) im Nullpunkt oder vor Erreichen des Nullpunkts wieder geöffnet ist.

2. Einrichtung nach Anspruch 1, dadurch gekennzeichnet, daß der Widerstand (R) nahezu Null ist und lediglich als Schutzwiderstand für die als mechanischer Schalter ausgebildete Schaltanordnung ($S_1$, $S_2$) dient.

3. Einrichtung nach Anspruch 1 oder 2, dadurch gekennzeichnet, daß der Widerstand (R) in Serie zum Eingang des Verstärkers (VV, EV) geschaltet ist.

4. Einrichtung nach einem der Ansprüche 1 bis 3, dadurch gekennzeichnet, daß die Schaltanordnung ($S_1$, $S_2$) einerseits am Widerstand (R) und andererseits an Masse liegt.

5. Einrichtung nach einem der Ansprüche 1 bis 3, dadurch gekennzeichnet, daß die Schaltanordnung ($S_1$, $S_2$) einerseits mit dem Widerstand (R) und andererseits mit einer Referenzspannung verbunden ist.

6. Einrichtung nach einem der Ansprüche 1 bis 5, dadurch gekennzeichnet, daß sie ein stark übersteuertes und damit aus der Eingangsspannung ein Rechtecksignal bildendes Differenzierglied (Diff.) enthält.

7. Einrichtung nach Anspruch 6, dadurch gekennzeichnet, daß dem Differenzierglied (Diff.) eine Komparatorstufe nachgeschaltet ist, die Scheitelimpulse erzeugt, mit denen die Zeitglieder (4 ms, 1 ms) triggerbar sind.

8. Einrichtung nach Anspruch 7, dadurch gekennzeichnet, daß die Komparatorstufe echte Scheitelimpulse vom Einschaltvorgang unterscheidet und daraus innerhalb weniger Millisekunden ein die Abschaltung der Wechselspannung angebendes Signal abgibt, wenn die Wechselspannung abgeschaltet worden ist.

9. Einrichtung nach einem der Ansprüche 1 bis 8, dadurch gekennzeichnet, daß die Komparatorstufe zwei Komparatoren enthält und das vom Differenzierglied erhaltene Signal (rs) mit einer positiven und einer negativen Schwellspannung derselben verglichen wird, und daß sich die Spannungen der beiden Komparatoren bei anstehendem Wechselspannungssignal immer in Phasenopposition, bei Wechselspannungswert Null aber in gleicher Phase befinden.

- - - - - - -

Fig. 1

Fig. 2

Nummer der Anmeldung

**Europäisches Patentamt**

## EUROPÄISCHER RECHERCHENBERICHT

| EINSCHLÄGIGE DOKUMENTE | | EP 84108287.8 |
|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ⅹ 4) |
|---|---|---|---|
| A,D | DE - A1 - 2 634 595 (GENERAL ELECTRIC)<br>* Fig. 2,3 *<br>-- | 1 | G 01 R 15/06 |
| A,D | DE - A1 - 2 846 285 (HAZEMEIJER)<br>* Fig. 1,6,7 *<br>-- | 1 | |
| A | DE - A - 1 541 891 (WESTING-HOUSE)<br>* Fig. 1 *<br>-- | | |
| A | DE - C - 656 983 (AEG)<br>* Abb. 2 *<br>---- | | |

| | | RECHERCHIERTE SACHGEBIETE (Int. Cl.3) 4 |
|---|---|---|
| | | G 01 R 15/00 |

Der vorliegende Recherchenbericht wurde für alle Patentansprüche erstellt.

| Recherchenort<br>WIEN | Abschlußdatum der Recherche<br>04-10-1984 | Prüfer<br>KUNZE |
|---|---|---|